# EUROPEAN PATENT APPLICATION

(11) **EP 4 628 828 A1**
(43) Date of publication of application: **08.10.2025**
(21) Application number: 23897798.7
(22) Date of filing: 29.11.2023
(51) Int. Cl.: F28D 15/02

(54) **HEAT DISSIPATION SUBSTRATE AND VAPOR CHAMBER**

(30) Priority: 30.11.2022 JP 2022190884
(71) Applicant: Kyocera Corporation, Kyoto-shi, Kyoto 612-8501 (JP)
(72) Inventor: KONISHI, Yoshitada, Kyoto-shi, Kyoto 612-8501 (JP)
(74) Representative: Viering, Jentschura & Partner mbB Patent- und Rechtsanwälte
(86) International application number: PCT/JP2023/042660
(87) International publication number: WO 2024/117151

(57) **Abstract**

A heat dissipation substrate includes a metal housing including a recess and a through hole, the through hole connecting an inside and an outside of the recess; a substrate bonded to the metal housing and covering the recess; and an alloy layer located on an inner wall surface of the through hole. The alloy layer includes a first layer and a second layer. The first layer is connected to the metal housing, includes, as a main component, a first component that is a main component of the metal housing, and includes a second component that is different from the first component. The second layer is located at a side facing the through hole, includes the second component as a main component, and includes the first component. The metal housing and the substrate may be bonded via an active brazing material.

## Description

### TECHNICAL FIELD

The present disclosure relates to a heat dissipation substrate and a vapor chamber.

### BACKGROUND OF INVENTION

A working liquid that is a liquid-phase fluid for transferring heat at a high speed is sealed in a cavity inside a heat pipe or a vapor chamber, which is used for efficient heat dissipation of an electronic device, parts, or the like. International Publication No. 2008/012960 discloses a technique of, after injecting such a liquid-phase fluid via an injection hole of a heat pipe, closing the injection hole by means of a sealing member.

### SUMMARY

An aspect of the present disclosure is a heat dissipation substrate including:
a metal housing including a recess and a through hole, the through hole connecting an inside and an outside of the recess;
a substrate bonded to the metal housing and covering the recess; and
an alloy layer located on an inner wall surface of the through hole.

The alloy layer includes:
a first layer connected to the metal housing, and including, as a main component, a first component that is a main component of the metal housing, and including a second component that is different from the first component, and
a second layer located at a side facing the through hole, and including the second component as a main component, and including the first component.

Another aspect of the present disclosure is a vapor chamber including:
the heat dissipation substrate stated above;
a sealing body configured to seal the through hole by being joined to the alloy layer; and
a liquid-phase fluid located inside the recess.

### BRIEF DESCRIPTION OF THE DRAWINGS

FIG. 1A is a plan view of a vapor chamber viewed from above.
FIG. 1B is a cross-sectional view taken along a cross-sectional line including a through hole of the vapor chamber.
FIG. 2A is a cross-sectional view illustrating the neighborhood of the through hole in a heat dissipation substrate in an enlarged manner.
FIG. 2B is a cross-sectional view illustrating the neighborhood of the through hole in the heat dissipation substrate in an enlarged manner.
FIG. 2C is a cross-sectional view illustrating the neighborhood of the through hole in a heat dissipation substrate according to a variation example in an enlarged manner.
FIG. 3A is a diagram for explaining the distribution of a copper component in an alloy layer.
FIG. 3B is a diagram for explaining the distribution of a silver component in the alloy layer.
FIG. 4 is a diagram for explaining the crystal grain structure of the alloy layer.
FIG. 5 is a diagram for schematically explaining the alloy layer.

### DESCRIPTION OF EMBODIMENTS

Based on the drawings, an embodiment will be described below.

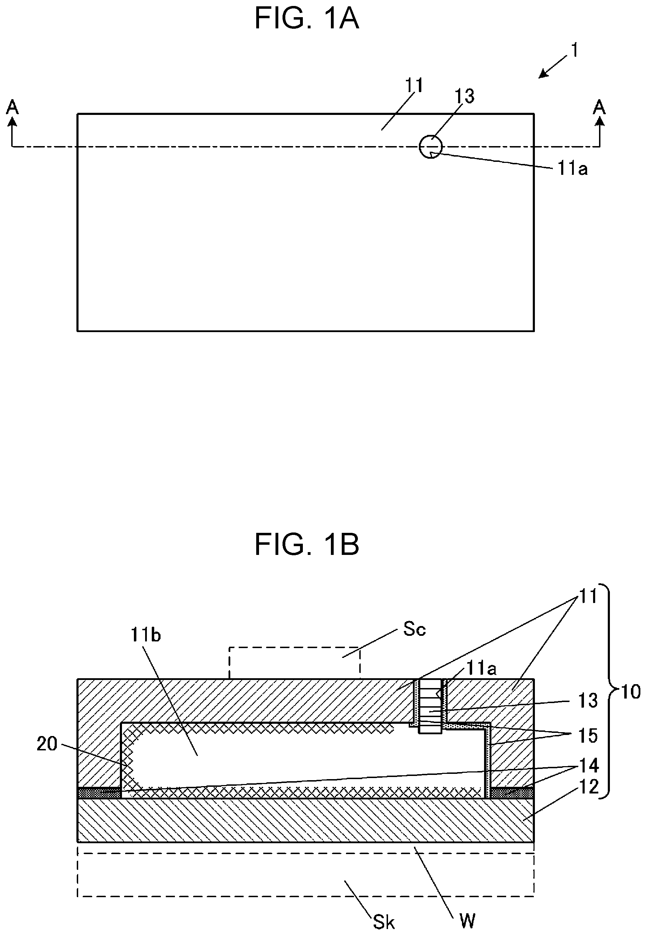

FIG. 1A is a plan view of a vapor chamber 1 according to the present embodiment viewed from above. FIG. 1B is a cross-sectional view taken along a cross-sectional line A-A, including a through hole 11a, of FIG. 1A. The term "above" as used herein does not have to be in concordance with an orientation in actual use. In the cross-sectional view of FIG. 1B, the height in the vertical direction of the drawing is shown to be greater than it actually is in terms of its scale relative to the width in the horizontal direction, for explanatory purposes.

The vapor chamber 1 may have, for example, a rectangular shape in a plan view, and may have a plate-like profile whose dimension in the vertical direction (height) is less than longitudinal/latitudinal plan-view dimension. The vapor chamber 1 receives the heat of a heat source Sc such as an IC chip connected to wiring, etc. on its upper surface, and transfers the heat to the lower-surface side. A heat dissipation plate Sk is bonded to the lower surface of the vapor chamber 1 using an active brazing material W, etc., such as silver solder. The heat transferred from the upper-surface side to the lower-surface side by the vapor chamber 1 is further transferred through the heat dissipation plate Sk and is then released into air, etc. from the heat dissipation plate Sk.

The vapor chamber 1 includes a heat dissipation substrate 10, a mesh structure 20 provided, with sealing, in an inner space of the heat dissipation substrate 10, and a liquid-phase fluid. The liquid-phase fluid is also called a working liquid. The mesh structure 20 is a voided structure with a three-dimensional network of voids. The voided structure used for a vapor chamber is called a wick. The mesh structure 20 is, for example, located along inner wall surfaces facing the inner space of the heat dissipation substrate 10 in such a way as to provide ceiling-to-floor continuity. A space that is not occupied by the mesh structure 20 may be left between the ceiling surface and the floor surface. The mesh structure 20 may be structured integrally with the heat dissipation substrate 10. The mesh structure 20 may be a metal or a ceramic.

The voided structure does not have to be cyclic as in a net pattern. The voided structure may be a stereo-structural object, etc. having many pores.

The mesh structure 20 allows the liquid-phase fluid to move quickly along its gaps by capillary action. By receiving the heat of the heat source Sc, the liquid-phase fluid present in the upper-surface-side gaps of the mesh structure 20 evaporates to turn into a gas-phase fluid, diffuses, and transfers the heat to the lower-surface side. The gas-phase fluid turned from the liquid-phase fluid due to the vaporization condenses by releasing the heat to the lower-surface side of the heat dissipation substrate 10 and thus liquefies back into a liquid-phase fluid. The liquid-phase fluid after the liquefaction returns quickly through the mesh structure 20 to the upper-surface side where the vaporization of the liquid-phase fluid is progressing. Due to repetition of this circulatory-flow cycles, the heat is transferred from the upper-surface side to the lower-surface side of the vapor chamber 1 with high thermal conductivity. Therefore, the heat of the heat source Sc is released from the heat dissipation plate Sk far faster than done by simple thermal conduction or the like. The liquid-phase fluid is, for example, pure water, but is not limited thereto. The liquid-phase fluid may be, for example, acetone, methanol, ammonia, etc., or may contain them. In consideration of volume expansion occurring at the time of the vaporization of the liquid-phase fluid, the inner space may be sealed to make its pressure lower than atmospheric pressure under usual conditions, that is, negative. The sealed amount of the mesh structure 20 and the liquid-phase fluid can be determined depending on the size of the inner space, the amount of heat to be transferred, and the like.

The heat dissipation substrate 10 includes a metal housing 11, which includes a through hole 11a and a recess 11b, a ceramic plate 12 (substrate), and a sealing body 13, which is located inside the through hole 11a. The metal housing 11 and the sealing body 13 contain an identical metal material as their main component. The main component may be copper. Alternatively, the main component of the sealing body 13 may be different from that of the metal housing 11. The ceramic plate 12 is an insulated substrate having high thermal conductivity, and its main component may be, for example, silicon nitride (Si₃N₄), silicon carbide (SiC), aluminum nitride (AlN), aluminum oxide (Al₂O₃), etc. The term "main component" as used herein means a component that accounts for 80 mass percent or greater of the total. Compositions may have component ratios that differ from each other though they include the same main component. Compositions may have component ratios that are considered to be the same within an error range defined by tolerance.

The through hole 11a provides straight connection between the inside and the outside of the recess 11b, and is used for injecting the liquid-phase fluid into the recess 11b therethrough. After the injection of the liquid-phase fluid, the through hole 11a is sealed by the sealing body 13. The diameter of the through hole 11a needed for the injection of the liquid-phase fluid may be, for example, φ = 0.5 to 2.0 mm, and the length of the through hole 11a may be, for example, 0.5 to 1.5 mm.

The metal housing 11 and the ceramic plate 12 are sealed by being bonded together using an active brazing material 14. The active brazing material 14 is, for example, silver solder, the main component of which is silver. This makes it possible to obtain airtightness with firm bonding between the metal housing 11 and the ceramic plate 12, and, in addition, improves thermal conductivity between the metal housing 11 and the ceramic plate 12 via the active brazing material 14. A plurality of metal housings 11 may be bonded to a single ceramic plate 12.

An alloy layer 15 is interposed for hermetic joining between the inner surface of the through hole 11a of the metal housing 11 and the sealing body 13. The alloy layer 15 is made of an alloy of silver and copper, and its component ratio is not uniform as will be described later.

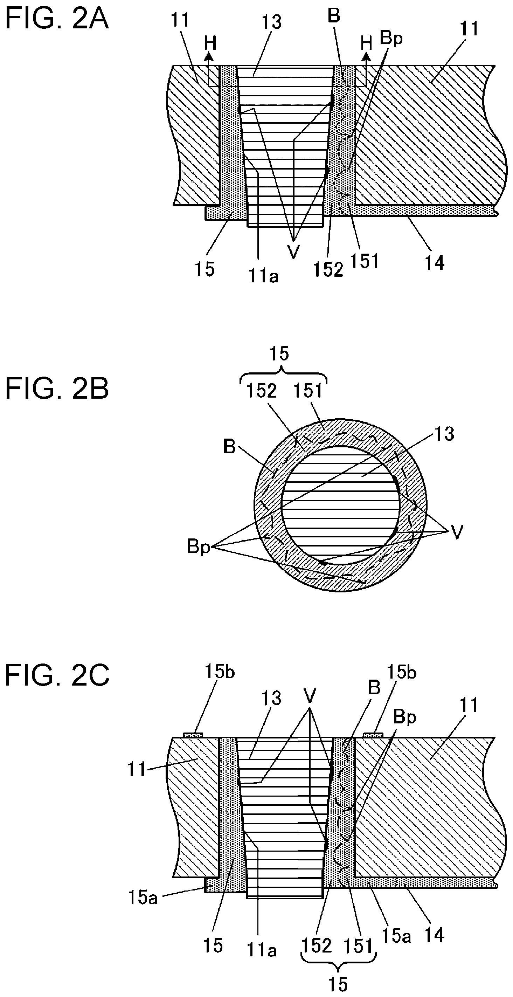

FIGS. 2A to 2C are cross-sectional views illustrating the neighborhood of the through hole 11a in the heat dissipation substrate 10 in an enlarged manner.

FIG. 2A is a cross-sectional view taken along the cross-sectional line A-A of FIG. 1A. FIG. 2B is a cross-sectional view taken along a cross-sectional line H-H of FIG. 2A.

As illustrated in FIGS. 2A and 2B, the entirety of the inner surface of the through hole 11a of the metal housing 11 may be the alloy layer 15, though not limited thereto. The alloy layer 15 may have an increasing thickness from the outside (the upper side in the drawing) of the recess of the metal housing 11 toward the inside (the lower side in the drawing) thereof. That is, the closer to the recess along the through hole 11a, the greater the thickness of the alloy layer 15 may be. In accordance with this, the closer to the recess, the smaller the diameter of the sealing body 13 may be. This thickness inclination is expressed in terms of plane-to-quadric-surface approximation, etc., and it does not preclude the localized presence of minor irregularities.

The alloy layer 15, which is made of an alloy of silver and copper, has a higher hardness than the sealing body 13, the main component of which is copper. Therefore, when the sealing body 13 is inserted into the through hole 11a, the closer to the recess 11b, the more it becomes compressed by the alloy layer 15. The cross-sectional size (width) of the alloy layer 15 in this state may be, for example, 150 µm or less at its maximum portion, meaning its portion near the end at the recess 11b here. However, the cross-sectional size of the alloy layer 15 is not limited to this example. This size can vary depending on various factors such as the size of the through hole 11a, the size of the metal housing 11, and/or the distance from the position of bonding by the active brazing material 14 to the through hole 11a.

As illustrated in FIG. 2B, the alloy layer 15 may have a uniform thickness in the circumferential direction of the through hole 11a, that is, in the direction of angular change with respect to the central axis of the through hole 11a. The term "uniform" as used herein means that, for example, variation in the thickness of the alloy layer 15 in the circumferential direction is 70% at the maximum, or 100 µm or less. Therefore, in this case, the sealing body 13 inserted into the through hole 11a receives a lateral stress substantially evenly.

The alloy layer 15 may include an alloy layer 15a, which is the portion running out of the inner surface of the through hole 11a onto the periphery therearound. In FIG. 2A, only the alloy layer 15a running into the recess lies. However, this does not imply any limitation. FIG. 2C illustrates a variation example of the cross-sectional shape illustrated in FIG. 2A. As illustrated in FIG. 2C, an alloy layer 15b may lie at the outside of the recess 11b, that is, on the outer surface of the metal housing 11. In this case, the thickness of the alloy layer 15b may be small enough so as not to significantly impair the planarity of the outer surface of the metal housing 11. The planarity may be obtained by surface cutting, surface grinding, or the like that is performed at the time of the insertion of, and sealing by, the sealing body 13. A part or the whole of the alloy layer 15b may be removed as a result of the cutting or the grinding. The alloy layer 15b may be isolated from the alloy layer 15 located along the inner wall surface of the through hole 11a. The alloy layer 15a located inside the recess 11b may be connected to the active brazing material 14, with an unclear boundary therebetween.

The alloy layer 15 can be demarcated into a first layer 151, which is connected to the metal housing 11, and a second layer 152, which abuts on the sealing body 13, by a boundary B. The first layer 151 is continuously connected to the metal housing 11. That is, the boundary between the first layer 151 and the metal housing 11 may be ambiguous. The first layer 151 includes, as its main component, a first component that is the main component of the metal housing 11, copper herein, with a second component mixed therein. The second component, silver herein, is different from the first component. The second layer 152 is clearly separated from the sealing body 13. The second layer 152 includes, as its main component, the second component that is the main component of the active brazing material 14, namely, silver, with the first component, namely, copper, mixed therein.

As described above, the hardness of the alloy layer 15 as a whole may be higher than that of each of silver and copper. The hardness of the first layer 151 and the hardness of the second layer 152 could differ according to their component ratios. The hardness of the second layer 152, which contains more silver, is lower than the hardness of the first layer 151.

Since the alloy layer 15, 15a, 15b, etc. is provided in such a way as to partially cover the periphery around the through hole 11a of the metal housing 11, when the sealing body 13 is press-fitted into the through hole 11a for sealing, its deformation is suppressed. In particular, the alloy layer 15a, 15b suppresses irregularities in the outer surface of the metal housing 11, for example, the subsidence of the neighborhood of the sealing body 13 or the like. Specifically, for example, the depth of a local cavity produced by the insertion of the sealing body 13 may be 100 µm or less, and the range (length) of the local cavity may be 200 µm or less. In a case where a signal line, or an electronic component or the like that is connected to the signal line and behaves as a heat source, lies on the outer surface of the metal housing 11, the planarity of the outer surface may be maintained.

A local void(s) V may exist at the boundary between the alloy layer 15 and the sealing body 13. The voids V may exist at a plurality of positions; however, they are sporadic. That is, the inside of the recess 11b is hermetically closed by the joining of the sealing body 13 and the second layer 152. The void V functions as a stress damper between the sealing body 13 and the metal housing 11, and as a buffer at the time of thermal expansion of each portion.

The boundary B between the first layer 151 and the second layer 152 may include wavy-pattern irregularities, instead of being smooth. Since the boundary between the first layer 151 and the second layer 152, between which there is a relative hardness difference, includes the irregularities, the stress caused by the thermal expansion of the sealing body or caused by an increase in internal pressure can be distributed moderately. Therefore, the deformation of the sealing surface is suppressed, and the airtightness is maintained effectively.

In particular, the boundary B may include a protruding portion Bp where the second layer 152 intrudes into the first layer 151 locally in a protruding manner at an acute angle. The term "acute angle" as used herein means that the viewing angle of the second layer 152 as viewed from the vertex of the protruding portion Bp in a plane that includes the vertex of the protruding portion Bp and the central axis of the through hole 11a is less than 90°. The viewing angle represents a range in which the sealing body 13 can be seen only through the second layer 152. As described above, the second layer 152, the hardness of which is relatively low in the alloy layer 15 having a high hardness as a whole, intrudes into the first layer 151. Therefore, the second layer 152 serves as wedges and a buffer at the joining surface. Even when a significant stress or a long-term stress is applied in the circumferential direction of the through hole 11a due to a difference in atmospheric pressure between the inside and the outside of the recess 11b, thermal expansion, or the like, the possibility of fracturing or cracking caused by its cumulative effects is reduced. Note that the irregularities of the boundary B themselves are irrelevant to the thickness of the alloy layer 15. Accordingly, the ratio of thickness between the first layer 151 and the second layer 152 may be varied widely. For example, the thickness of the second layer 152 may be locally zero, meaning that the second layer 152 may be split in a plurality of portions and/or may have an opening(s). In this case, there may be a portion where the first layer 151 is joined to the sealing body 13 directly. Since the second layer 152 is securely joined to the sealing body 13 in a sporadic manner, the stress is distributed to each joining portion, and the airtightness can be kept.

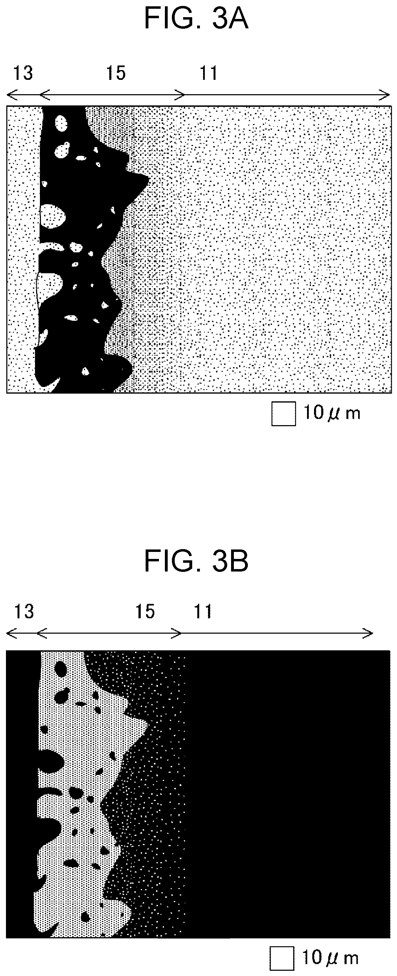

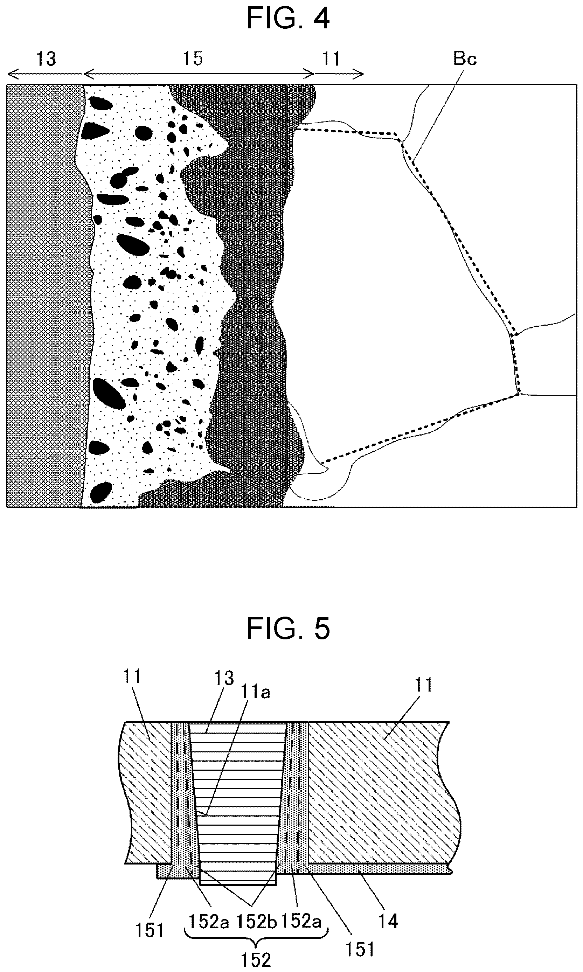

FIGS. 3A to 3C, 4, and 5 are diagrams that schematically illustrate an example of the cross-sectional structure of the alloy layer 15. FIG. 3A illustrates the distribution of the copper component. FIG. 3B illustrates the distribution of the silver component. FIG. 4 is a diagram for explaining crystal grain size. FIGS. 3A, 3B, and 4 provide a schematic view, in an enlarged manner, of a part of the cross section illustrated in FIG. 2A. FIG. 5 is a diagram illustrating the alloy layer 15 with a further breakdown into regions in a simplified manner. To simplify the explanation, in FIG. 5, the boundary irregularities, the voids V, and the like that are illustrated in FIG. 2A are omitted.

As illustrated in FIGS. 3A and 3B, the first layer 151, which is located at a position relatively close to the metal housing 11 in the alloy layer 15, is continuous from the metal housing 11 and contains copper, the first component, as its main component. Silver, the second component, may be finely mixed therein. The ratio of the silver component may diminish gradually from the boundary abutting the second layer 152 toward the boundary abutting the metal housing 11. In accordance with this, the density of the first layer 151 may also diminish gradually from the boundary abutting the second layer 152 toward the boundary abutting the metal housing 11. Specifically, the ratio of the silver component may be 10% at the maximum, 5% on average. The crystal grain size of copper in the first layer 151 may be smaller than the crystal grain size of copper in the metal housing 11.

As illustrated in FIG. 4, in the metal housing 11, the crystal grain size of copper demarcated by a boundary Bc may be often a size corresponding to the thickness of the alloy layer 15 or greater, for example, a size of 200 µm or so on average. By contrast, as illustrated in FIG. 3A, in the first layer 151, silver atoms (particles) may be mixed in a dispersed manner. The crystal grain size of copper may be extremely small within a range of clearance between them, for example, a size of 10 µm or so on average. Each individual crystal grain size may be non-uniform.

The component ratio and the grain size described above may be found by, for example, identifying the region of each component from images of the copper component and the silver component obtained using energy dispersive spectroscopy (EDS) or the like.

On the other hand, as illustrated in FIG. 3B, in the second layer 152, the crystals of copper, the first component, are mixed in the second component, namely, silver, which is its main component. The crystal component of copper may include those grown such that, the farther from the neighborhood of the boundary B, the greater the crystal grain size. That is, in the second layer 152, the maximum value of the crystal grain size may increase as the distance from the boundary B increases. Specifically, as an example, the size of the crystal component of copper may increase from 0.5 µm or so to 10 µm or so in the second layer 152. Copper atoms having entered the layer of the active brazing material 14 from the metal housing 11 are hard to grow large in the neighborhood of the boundary. As a result of this difficulty in crystal growth, the second layer 152, if simplified, may have a structure that an intermediate layer 152a, the crystal growth of copper of which is relatively low, and a joining layer 152b, the crystal growth of copper of which is relatively high, are continuously connected to each other.

As described above, silver has a lower modulus of elasticity and a higher coefficient of thermal expansion than copper. That is, the layer that has the lowest modulus of elasticity and the lowest hardness lies not in the joining layer 152b, which faces the sealing body 13 at the joining surface, but in the intermediate layer 152a. Therefore, the copper crystal is relatively influential in joining with the sealing body, and joining characteristics between the identical components, the same as that of the sealing body 13, are easier to be obtained. Meanwhile, the intermediate layer 152a tolerates deformation between the joining surface and the metal housing 11 and can serve as a buffer. Therefore, the heat dissipation substrate 10 is less susceptible to deformation in the neighborhood of the joining surface between the sealing body 13 and the second layer 152, making it easier to maintain the airtightness.

As described above, the crystals of the component that is different from the main component are distributed inside each layer, and its change is not discontinuous, making local deformation between the regions less likely to occur.

The structure described above may be obtained by the active brazing material 14 climbing along the inner wall surface of the recess 11b and by its part covering the inner wall surface of the through hole 11a when the metal housing 11 and the ceramic plate 12 are bonded together using the active brazing material 14. The active brazing material 14 having a high temperature abuts on the metal housing 11 at the boundary B, and a part of copper atoms and a part of silver atoms transfer across the boundary B, thereby forming the alloy layer 15 at both sides with respect to the boundary B. In particular, since silver atoms move preferentially to the grain boundary of copper, the boundary B is prone to be wavy. The thickness of the alloy layer 15 is prone to be greater at, of the through hole 11a, the side closer to the recess 11b, meaning the side from which the active brazing material 14 flows in.

In this way, the active brazing material 14 interacts with the metal housing 11 only; therefore, the boundary between the sealing body 13 and the alloy layer 15 is clear as described earlier. In the process of sealing by the sealing body 13, the sealing body 13 itself is securely pressure-joined to the alloy layer 15.

There is a need for the active brazing material 14 to flow in along the inner wall surface of the through hole 11a. Therefore, the through hole 11a may be located near the bonding position of the metal housing 11 and the ceramic plate 12, that is, in the neighborhood of an edge of the metal housing 11 in a plan view. For example, the through hole 11a may be located near a certain corner of the metal housing 11 having a rectangular shape in a plan view. A sidewall surface constituting an edge of the recess 11b of the metal housing 11, and the bottom surface of the recess 11b opposite to an opening covered by the ceramic plate 12, may be planar, at least around the through hole 11a. If the sidewall surface has a step, irregularities, or the like, the active brazing material 14 is likely to struggle to flow into the through hole 11a properly. The wall-surface shape does not necessarily have to be planar as long as there is no significant adverse influence on the flow of the active brazing material 14.

As described above, the heat dissipation substrate 10 according to the present embodiment includes: the metal housing 11 including the recess 11b and the through hole 11a, the through hole 11a connecting an inside and an outside of the recess 11b; the ceramic plate 12 as a substrate bonded to the metal housing 11 and covering the recess 11b; and the alloy layer 15 located on an inner wall surface of the through hole 11a. The alloy layer 15 includes the first layer 151 and the second layer 152. The first layer 151 is connected to the metal housing 11, and includes, as its main component, a first component that is the main component of the metal housing 11, copper herein, and includes a second component, silver, that is different from the first component. The second layer 152 is located at a side facing the through hole 11a, and includes the second component, silver, as its main component, and includes the first component, copper. As described above, in the heat dissipation substrate 10, the alloy layer 15, the material of which is different from that of the metal housing 11 and the sealing body 13, is located on the inner wall surface of the through hole 11a, and the metal housing 11 and the sealing body 13 are joined, with the alloy layer 15 interposed therebetween. Therefore, the heat dissipation substrate 10, and thus the vapor chamber 1, can enhance the strength of joining at the time of joining of the sealing body 13 and can offer firmer sealing than in related art. In particular, since layers whose physical properties are different from each other are interposed between the targets of joining, durability against deformation under stress applied at the time of manufacturing and/or at the time of operation improves, and hermetic performance improves. Since the alloy layer 15 includes the first layer 151 and the second layer 152 whose component ratios are different from each other, both joining stability and stress distribution are achieved.

The metal housing 11 and the ceramic plate 12 (substrate) may be bonded via the active brazing material 14. Since this bonds the ceramic plate 12 to the metal housing 11 firmly, the heat dissipation substrate 10 has a firmer structure with higher durability.

The second component, silver, may be the main component of the active brazing material 14. That is, silver solder may be used for the bonding. The alloy layer 15 described above is obtained by the active brazing material 14 flowing along the inner surface of the through hole 11a from the inside of the recess 11b at the time of the bonding of the ceramic plate 12 using the active brazing material 14. Therefore, silver solder works effectively not only for the bonding of the ceramic plate 12 but also for the firm joining of the sealing body 13, making it possible to enhance the robustness of the heat dissipation substrate 10 efficiently.

The main component of the first layer is copper, and the main component of the second layer is silver. An alloy of copper and silver can achieve a higher hardness than copper alone and silver alone. Therefore, the heat dissipation substrate 10 that is robust can be obtained using a material having a high thermal conductivity.

The alloy layer 15 may have an increasing thickness from the outside toward the inside of the recess 11b along the through hole 11a. That is, the inner surface of the through hole 11a may be configured such that, the closer to the recess 11b, the thicker and harder the alloy layer 15. Therefore, the heat dissipation substrate 10 makes insertion easier in the process of press fitting of the sealing body 13 and ensures airtightness while suppressing deformation.

The alloy layer 15 may have a uniform thickness in a circumferential direction of the through hole 11a. With this structure, a stress is applied to the sealing body 13 substantially evenly. Therefore, the heat dissipation substrate 10 can reduce the risk of an excessive load being applied to a specific part, which could compromise its airtightness.

The alloy layer 15 may be located also at a periphery outside the through hole 11a. That is, the alloy layer 15 having a high hardness may extend onto a surface perpendicular to the direction of press fitting of the sealing body 13 and the direction of expansion/contraction caused by a pressure change inside. Therefore, a change in shape of the upper surface of the metal housing 11 during manufacturing and/or during use is suppressed, making it possible to hold the heat source Sc stably. In addition, deterioration in the joining surface due to the stress incurred from the deformation can be reduced.

An alloy layer 15b located on an outer surface of the metal housing 11 opposite to the recess 11b, that is, located on the upper surface of the heat dissipation substrate 10, may include a portion isolated from the alloy layer 15 located along the through hole 11a. The upper surface of the heat dissipation substrate 10, on which the heat source Sc is placed and fixed, is required to have planarity. Therefore, the alloy layer 15b may be isolated from the alloy layer 15 on the inner wall surface of the through hole 11a by the cutting, grinding, etc. of the upper surface. This structure can also enhance the strength of the upper surface of the heat dissipation substrate 10 and thus enhance the durability of the heat dissipation substrate 10.

The second layer 152 may be separated into a plurality of portions. The second layer 152, the strength of which is relatively low in comparison with the strength of the first layer 151, is separated to enable connection of the sealing body 13 and the first layer 151 at a plurality of places; therefore, a stress applied to the second layer 152 serving as a buffer can be distributed properly. This makes it possible to maintain the joining strength of the heat dissipation substrate 10 and enhance the durability of an airtight state.

A crystal grain size of copper in the first layer 151 is smaller than a crystal grain size of copper in the metal housing 11, and, in the first layer 151, the closer to the metal housing 11, the lower a density of silver. The smaller crystal grain size of copper reduces dislocation slip in the crystal grains, thereby decreasing the occurrence of plastic deformation. Therefore, the structure in a joined state of the heat dissipation substrate 10 is maintained firmly, and its durability improves. Since the density of silver increases gradually from the boundary abutting the metal housing 11 toward the boundary abutting the sealing body 13, the hardness changes continuously. Therefore, in the heat dissipation substrate 10, the joining between the metal housing 11 and the sealing body 13 is flexible, which acts for stress distribution, making it easier to keep a sealed state for a long period of time.

The farther from the first layer 151, the larger the crystal grain size of copper in the second layer 152 may be. With this structure, the decrease in the hardness of the alloy layer 15 is small in a region that is in close proximity to the joining surface between the sealing body 13 and the alloy layer 15. Therefore, the heat dissipation substrate 10 is less susceptible to deformation along the joining surface, making it easier to maintain the airtightness. On the other hand, the heat dissipation substrate 10 includes a region where the hardness decrease is larger than at the above-mentioned region of close proximity to the joining surface, as it goes farther from the joining surface toward the metal housing 11 in the alloy layer 15. Therefore, the stress is distributed properly, and the joined state of the heat dissipation substrate 10 is kept to be firm.

A boundary between the first layer 151 and the second layer 152 may have irregularities. With this structure, even when a shear stress is applied in the circumferential direction between the two layers with different degrees of hardness, a shear displacement at the joining surface is not easily produced, and a rupture in the airtight seal does not occur easily. Therefore, the heat dissipation substrate 10 with a high durability can be obtained.

The boundary may include a portion where the second layer 152 protrudes toward the first layer 151 at an acute angle. Since this intruding portion of the second layer 152 serves as a wedge, a rupture in the joining caused by the shear stress mentioned above, that is, a rupture in the airtight seal, does not occur easily. In addition, since the stress is distributed moderately, the joined state can be maintained stably.

The heat dissipation substrate 10 may further include: the sealing body 13 configured to seal the through hole 11a by being joined to the alloy layer 15. The heat dissipation substrate 10 may further include: a local void(s) V between the sealing body 13 and the alloy layer 15. In the heat dissipation substrate 10, the void(s) V that is easily deformable serves as a buffer layer to moderately relax the stress caused by expansion/contraction due to a change in pressure of the sealed inner space and/or due to thermal expansion during manufacturing and/or during use. Therefore, the durability of the heat dissipation substrate 10 improves.

The vapor chamber 1 according to the present embodiment includes the heat dissipation substrate 10 described above; the sealing body 13; and a liquid-phase fluid located inside the recess 11b. The vapor chamber 1 having this configuration enhances the planarity of the upper surface of the metal housing 11 to release the heat of the heat source Sc efficiently, and can maintain its durability stably.

The embodiment described above is just an example, and various changes can be made thereto.

For example, the alloy structure described above is not limited to a case where the first component that is the main component of the metal housing 11 and the sealing body 13 is copper, and the second component that is the main component of the active brazing material 14 is silver. It is sufficient as long as the alloy layer 15 that includes the first layer 151 and the second layer 152 can be formed of the main components. The hardness of the alloy layer 15 may be higher than the hardness of the metal housing 11 and the sealing body 13. The boundary B between the first layer 151 and the second layer 152 may have irregularities, and either one of these layers may intrude into the other of these layers by its protruding portion with an acute angle.

According to the foregoing description, the alloy layer 15 is obtained by the active brazing material 14 flowing into the through hole 11a at the time of the bonding of the ceramic plate 12; however, this does not imply any limitation. Also in a case where a metal substrate and/or a resin substrate are/is bonded to the metal housing 11 using the active brazing material 14, similarly, the alloy layer 15 is obtained by the active brazing material 14 flowing into the through hole 11a. The alloy layer 15 may be formed independently of the bonding of the ceramic plate 12, etc. In accordance with the above, or irrespective of the above, the alloy layer 15 may be configured not to be flanged out of the inner surface of the through hole 11a. The alloy layer 15b located on the outer surface of the metal housing 11 may be continuous to the alloy layer 15 located along the inner wall surface of the through hole 11a. The metal housing 11 and the ceramic plate 12 may be bonded together using any other means instead of the active brazing material 14. The through hole 11a does not necessarily have to be located in the neighborhood of an edge of the metal housing 11 in a plan view.

The heat dissipation substrate 10 may be configured not to have a change in thickness of the alloy layer 15 in the through-hole direction along the inner wall surface of the through hole 11a. The alloy layer 15 may be configured not to extend throughout the entire inner wall surface.

The alloy layer 15 may be configured not to exhibit a change in crystal grain size of copper according to the distance from the metal housing 11, a change in silver density, namely, a change in component ratio between copper and silver, and the like.

The shape of the through hole 11a and the sealing body 13 does not necessarily have to be a round column. For example, the through hole 11a and the sealing body 13 may have an elliptical columnar shape, a polygonal columnar shape, or the like. Alternatively, the through hole 11a and the sealing body 13 may have a polygonal columnar shape with rounded corners, or a non-uniform shape such as a combination of a curved portion and a straight portion in a plan view or in a cross-sectional view taken perpendicularly to the direction in which the through hole 11a extends, or the like.

The voids V along the surface of the sealing body 13 may be omitted.

The ceramic plate 12 may be non-planar. Depending on the shape, size, etc. of the heat dissipation plate Sk, there may be irregularities or a curved portion.

The foregoing description does not preclude the presence of any other component, though silver and copper only have been mentioned.

Though the vapor chamber 1 with the liquid-phase fluid already injected and with sealing already done by the sealing body 13 has been described above, the heat dissipation substrate 10 before the injection/sealing may be independently on the market, etc.

The other content of the foregoing embodiment such as its specific configuration, structure, material, manufacturing method, and the like can be changed as appropriate within a range of not departing from the spirit of the present disclosure. The scope of the present invention encompasses the scope of the invention recited in the appended claims and the scope equivalent thereto.

### INDUSTRIAL APPLICABILITY

The present disclosure can be applied to a heat dissipation substrate and a vapor chamber.

### REFERENCE SIGNS

1 vapor chamber
10 heat dissipation substrate
11 metal housing
11a through hole
11b recess
12 ceramic plate
13 sealing body
15, 15a, 15b alloy layer
151 first layer
152 second layer
152a intermediate layer
152b joining layer
20 mesh structure
B, Bc boundary
Bp protruding portion
V void

## Claims

1. A heat dissipation substrate comprising:
a metal housing including a recess and a through hole, the through hole connecting an inside and an outside of the recess;
a substrate bonded to the metal housing and covering the recess; and
an alloy layer located on an inner wall surface of the through hole,
the alloy layer including
a first layer connected to the metal housing, and including, as a main component, a first component that is a main component of the metal housing, and including a second component that is different from the first component, and
a second layer located at a side facing the through hole, and including the second component as a main component, and including the first component.

2. The heat dissipation substrate according to claim 1, wherein
the metal housing and the substrate are bonded via an active brazing material.

3. The heat dissipation substrate according to claim 2, wherein
the second component is a main component of the active brazing material.

4. The heat dissipation substrate according to any of claims 1 to 3, wherein
the first component is copper, and the second component is silver.

5. The heat dissipation substrate according to any of claims 1 to 4, wherein
the alloy layer has an increasing thickness from the outside toward the inside of the recess along the through hole.

6. The heat dissipation substrate according to any of claims 1 to 5, wherein
the alloy layer has a uniform thickness in a circumferential direction of the through hole.

7. The heat dissipation substrate according to any of claims 1 to 6, wherein
the alloy layer is located also at a periphery outside the through hole.

8. The heat dissipation substrate according to claim 7, wherein
an alloy layer located on an outer surface of the metal housing opposite to the recess includes a portion isolated from the alloy layer located along the through hole.

9. The heat dissipation substrate according to any of claims 1 to 8, wherein
the second layer is separated into a plurality of portions.

10. The heat dissipation substrate according to any of claims 1 to 9, wherein
a crystal grain size of the first component in the first layer is smaller than a crystal grain size of the first component in the metal housing, and, in the first layer, the closer to the metal housing, the lower a density of the second component.

11. The heat dissipation substrate according to any of claims 1 to 10, wherein
the farther from the first layer, the larger a crystal grain size of the first component in the second layer.

12. The heat dissipation substrate according to any of claims 1 to 11, wherein
a boundary between the first layer and the second layer has irregularities.

13. The heat dissipation substrate according to claim 12, wherein
the boundary includes a portion where the second layer protrudes toward the first layer at an acute angle.

14. The heat dissipation substrate according to any of claims 1 to 13, further comprising:
a sealing body configured to seal the through hole by being joined to the alloy layer, wherein
a local void is provided between the sealing body and the alloy layer.

15. A vapor chamber comprising:
the heat dissipation substrate according to any of claims 1 to 14;
a sealing body configured to seal the through hole by being joined to the alloy layer; and
a liquid-phase fluid located inside the recess.
